# EUROPÄISCHE PATENTSCHRIFT

(11) **EP 3 053 270 B1**
(45) Veröffentlichungstag und Bekanntmachung des Hinweises auf die Patenterteilung: **19.06.2019**
(21) Anmeldenummer: 14759227.3
(22) Anmeldetag: 08.09.2014
(51) Int. Cl.: H03K 17/16, H03K 17/082, H03K 17/74, H03K 17/14, H03K 17/30

(54) **INVERTSCHALTUNG MIT SPANNUNGSBEGRENZUNG**
INVERTER CIRCUIT WITH VOLTAGE LIMITATION
CIRCUIT INVERSEUR À LIMITATION DE TENSION

(30) Priorität: 30.09.2013 DE 102013219670
(43) Veröffentlichungstag der Anmeldung: 10.08.2016
(73) Patentinhaber: Robert Bosch GmbH, 70442 Stuttgart (DE); Samsung SDI Co., Ltd., Yongin-si, Gyeonggi-do 446-577 (KR)
(72) Erfinder: BUTZMANN, Stefan, 58579 Schalksmühle (DE)
(74) Vertreter: Bee, Joachim
(86) Internationale Anmeldenummer: PCT/EP2014/069061
(87) Internationale Veröffentlichungsnummer: WO 2015/043936

(56) Entgegenhaltungen:
- EP-A2- 0 730 331
- DE-A1-102010 008 815
- DE-T2-602004 004 669

## Beschreibung

Die vorliegende Erfindung betrifft eine Inverterschaltung, welche ein erstes und ein zweites Schaltmittel umfasst, welche in einem elektrischen Pfad zueinander in Reihe und zu einem Zwischenkreiskondensator parallel geschaltet sind und deren Steueranschlüsse jeweils mit einer Pulssteuereinrichtung verbunden sind. Die Inverterschaltung umfasst ferner einen Ausgang und zwei Eingänge, welche jeweils elektrisch leitfähig mit einem Pol des Zwischenkreiskondensators verbunden und mit jeweils einem Pol eines Energiespeichers verbindbar sind sowie ein Spannungsbegrenzungselement, welches mit einem ersten Anschluss zwischen den beiden Schaltmitteln mit dem elektrischen Pfad und mit einem zweiten Anschluss mit dem Steueranschluss des zweiten Schaltmittels elektrisch leitfähig verbunden ist.

### Stand der Technik

Inverterschaltungen, auch einfach Inverter oder Wechselrichter genannt, sind eine der wichtigsten Bestandteile in elektrischen Antrieben, insbesondere in elektrischen Antrieben, die von einer Gleichspannung gespeist werden. In der DE 3415011 A1 ist eine solche Inverterschaltung, dort als Invertiereinrichtung bezeichnet, offenbart. Genauer ausgedrückt wird in der DE 3415011 A1 eine Invertiereinrichtung mit Halbleiter-Stromsteuerelementen beschrieben, bei der eine Parallelschaltung aus einer strombegrenzenden Schaltung und einer Diode in Serie verbunden ist mit jedem der Halbleiter-Stromsteuerelemente, um zu verhindern, dass ein übermäßiger Strom durch die letzteren fließt.

Die EP 0 730 331 A2 offenbart eine Schaltungsanordnung zur Begrenzung von Schaltüberspannungen an Leistungshalbleiterschaltern, bei der ein Spannungsteiler mit der Quellspannung der Schaltung versorgt wird und durch ein an einem Angriffspunkt des Spannungsteilers abgreifbares Signal die Leistungshalbschalter in einen leitenden Zustand schaltbar sind.

Ferner offenbart beispielsweise die DE 10 2009 014 704 A1 ein Antriebssystem und ein Verfahren zum Betreiben eines Antriebssystems, welches einen Elektromotor, einen Wechselrichter und einen Energiespeicher umfasst, wobei der Elektromotor von dem Wechselrichter speisbar ist und wobei zumindest einer Statorwicklung des Elektromotors ein von einem Schalter steuerbarer Strom zuführbar ist, der aus einer vom Energiespeicher unterschiedlichen elektrischen Energiequelle versorgt ist.

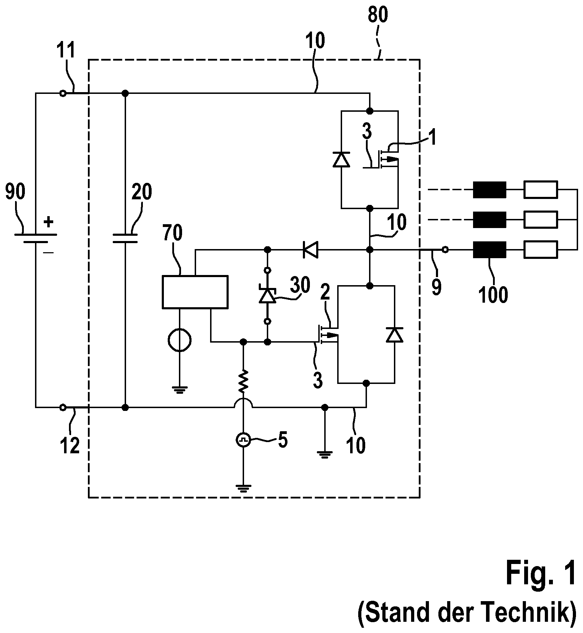

Des Weiteren ist in der DE 60 2004 004 669 T2 eine Steuereinrichtung für einen mit einer Batterie und einem Bordnetz verbundenen mehrphasigen und reversiblen Anlassergenerator beschrieben, welcher einerseits eine Brücke mit Schaltern in Form von Leistungstransistoren und andererseits eine elektronische Steuer- und Kontrolleinheit mit Ansteuervorrichtungen zur Ansteuerung der Gates der Leistungstransistoren umfasst. Die Figur 1 zeigt eine weitere Inverterschaltung 80 des Standes der Technik in einem mit einem Energiespeicher 90 und einer Last 100 verbundenen Zustand. Die Inverterschaltung 80 umfasst ein erstes und ein zweites Schaltmittel 1, 2, welche in einem elektrischen Pfad 10 zueinander in Reihe und zu einem Zwischenkreiskondensator 20 parallel geschaltet sind und deren Steueranschlüsse 3 jeweils mit einer Pulssteuereinrichtung 5 verbunden sind, was in diesem Beispiel einer Inverterschaltung 80 des Standes der Technik lediglich für das untere, zweite Schaltmittel 2 dargestellt ist. Ferner umfasst die Inverterschaltung 80 einen Ausgang 9, welcher in diesem Beispiel zwischen dem ersten und dem zweiten Schaltmittel 1, 2 mit dem elektrischen Pfad 10 elektrisch leitfähig verbunden ist, und zwei Eingänge 11, 12, welche jeweils elektrisch leitfähig mit einem Pol des Zwischenkreiskondensators 20 und mit jeweils einem Pol eines Energiespeichers 90 verbunden sind. Des Weiteren umfasst die Inverterschaltung 80 des Standes der Technik ein Spannungsbegrenzungselement 30, welches mit seinem ersten Anschluss zwischen den beiden Schaltmitteln 1, 2 mit dem elektrischen Pfad 10 und mit seinem zweiten Anschluss mit dem Steueranschluss 3 des zweiten Schaltmittels 2 elektrisch leitfähig verbunden ist. In diesem Beispiel ist das Spannungsbegrenzungselement 30 als Zener-Diode 30 ausgeführt.

Das Spannungsbegrenzungselement 30 dient dazu, am Ausgang 9, dass heißt zwischen dem ersten und dem zweiten Schaltmittel 1, 2 im elektrischen Pfad 10, auftretende Spannungsspitzen zu brechen. Tritt am Ausgang 9 beziehungsweise zwischen dem ersten und dem zweiten Schaltmittel 1, 2 im elektrischen Pfad 10, beispielsweise aufgrund eines unterbrochenen Stromflusses in der Last 100 eine Spannungsspitze auf, so wird bei der Überschreitung der Durchbruchspannung der Zenerdiode 30 das zweite Schaltmittel 2 angesteuert, um einen gewissen Stromfluss zu ermöglichen und die Spannungsspitze abzubauen. Zusätzlich befindet sich eine Regelschaltung 70 in der Inverterschaltung 80, welche die Spannung am Ausgang 9 über einen Eingriff auf den Steueranschluss 3 des zweiten Schaltmittels 2 begrenzt, jedoch meist nur wenig Dynamik besitzt und kurze Überspannungsspitzen nicht ausregeln kann. Ferner ist an der in Figur 1 dargestellten Inverterschaltung 80 problematisch, dass die Spannung am Ausgang 9 beziehungsweise zwischen dem ersten und zweiten Schaltmittel 1, 2 im elektrischen Pfad 10 mit zunehmender Alterung bei Temperaturschwankungen und aufgrund von Toleranzen der Bauteile wandern kann. So ist beispielsweise bei einer Designspannung von 400 V eine Variation um +/- 50 V möglich. Somit kann auch die am Zwischenkreiskondensator 20 anliegende Spannung größer als die Designspannung sein, wonach der Zwischenkreiskondensator 20 wie auch die übrigen Bauteile dimensioniert sein müssen.

### Offenbarung der Erfindung

Erfindungsgemäß wird eine Inverterschaltung bereitgestellt, welche ein erstes und ein zweites Schaltmittel umfasst, welche in einem elektrischen Pfad zueinander in Reihe und zu einem Zwischenkreiskondensator parallel geschaltet sind und deren Steueranschlüsse jeweils mit einer Pulssteuereinrichtung verbunden sind. Die Inverterschaltung umfasst ferner einen Ausgang und zwei Eingänge, welche jeweils elektrisch leitfähig mit einem Pol des Zwischenkreiskondensators verbunden und mit jeweils einem Pol eines Energiespeichers verbindbar sind. Des Weiteren weist die Inverterschaltung ein Spannungsbegrenzungselement auf, welches mit einem ersten Anschluss zwischen den beiden Schaltmitteln mit dem elektrischen Pfad und mit einem zweiten Anschluss mit dem Steueranschluss des zweiten Schaltmittels elektrisch leitfähig verbunden ist. Erfindungsgemäß ist ein Kondensator in der elektrisch leitfähigen Verbindung zwischen dem Spannungsbegrenzungselement und dem Steueranschluss des zweiten Schaltmittels angeordnet und eine Referenzspannungsquelle elektrisch leitfähig mit dem ersten Anschluss des Spannungsbegrenzungselementes verbunden.

Der Vorteil einer derart ausgeführten Inverterschaltung ist, dass selbige die Basis für den schnellen und sehr genauen Abbau von zwischen dem ersten und dem zweiten Schaltmittel im elektrischen Pfad auftretenden Spannungsspitzen bereitstellt. In einer erfindungsgemäß ausgeführten Inverterschaltung können daher, verglichen mit den Inverterschaltungen des Standes der Technik, kleiner dimensionierte Zwischenkreiskondensatoren beziehungsweise Schaltungsbauteile verwandt werden, da Überspannungen sofort abgebaut werden.

Bevorzugt umfasst die Inverterschaltung ferner eine erste Diode, welche in der elektrisch leitfähigen Verbindung zwischen dem ersten Anschluss des Spannungsbegrenzungselementes und dem elektrischen Pfad angeordnet ist. Ferner bevorzugt ist die Kathode der ersten Diode elektrisch leitfähig mit dem ersten Anschluss des Spannungsbegrenzungselementes verbunden, während die Anode der ersten Diode elektrisch leitfähig mit dem elektrischen Pfad verbunden ist. In einem solchen Ausführungsbeispiel verhindert die erste Diode die Weitergabe der von der Referenzspannungsquelle bereitgestellten Referenzspannung.

Vorzugsweise umfasst die Inverterschaltung ferner eine zweite Diode, welche in der elektrisch leitfähigen Verbindung zwischen der Referenzspannungsquelle und dem ersten Anschluss des Spannungsbegrenzungselementes angeordnet ist. Bevorzugt ist die Kathode der zweiten Diode elektrisch leitfähig mit dem ersten Anschluss des Spannungsbegrenzungselementes verbunden, während die Anode der zweiten Diode elektrisch leitfähig mit der Referenzspannungsquelle verbunden ist. In einem solchen Ausführungsbeispiel ist durch die zweite Diode sichergestellt, dass zu keinem Zeitpunkt ein Strom in die Referenzspannungsquelle zurückfließt. Dies erhöht die Sicherheit beziehungsweise die Stabilität der Inverterschaltung.

Erfindungsgemäß gilt für die Referenzspannung Ur, welche von der Referenzspannungsquelle bereitgestellt wird, Ur = Uc + Uspb, wobei Uc der Spannung am Kondensator im vollgeladenen Zustand entspricht und Uspb der Durchbruchspannung des Spannungsbegrenzungselementes entspricht. Mit anderen Worten ausgedrückt, ist die von der Referenzspannungsquelle bereitstellbare Referenzspannung Ur so eingestellt beziehungsweise gewählt, In einer bevorzugten Ausführungsform gilt für die Referenzspannung Ur, welche von der Referenzspannungsquelle bereitgestellt wird, Ur = Uc + Uspb, wobei Uc der Spannung am Kondensator im vollgeladenen Zustand entspricht und Uspb der Durchbruchspannung des Spannungsbegrenzungselementes entspricht. Mit anderen Worten ausgedrückt, ist die von der Referenzspannungsquelle bereitstellbare Referenzspannung Ur so eingestellt beziehungsweise gewählt, dass die über dem Spannungsbegrenzungselement abfallende Spannung im vollgeladenen Zustand des Kondensators genau gleich der Durchbruchspannung des Spannungsbegrenzungselementes Uspb ist. Der Vorteil einer derartigen Ausführung der Inverterschaltung ist, dass eine Alterung des Spannungsbegrenzungselementes sowie eine beispielsweise durch eine Alterung bewirkte Änderung der für einen Durchbruch des Spannungsbegrenzungselementes benötigten Durchbruchspannung, keinen Einfluss auf den sicheren Abbau von zwischen dem ersten und dem zweiten Schaltmittel im elektrischen Pfad auftretenden Spannungsspitzen hat. Auch Toleranzen der in der Inverterschaltung verbauten Bauteile wirken sich nicht auf die Funktionalität der Schaltung im oben genannten Sinne aus.

Vorzugsweise ist das Spannungsbegrenzungselement als Zener-Diode ausgeführt. Durch eine Zener-Diode lassen sich Spannungen sehr genau auf einen zuvor festgelegten Wert begrenzen.

In einer bevorzugten Ausführungsform umfasst die Inverterschaltung ferner eine Regelschaltung, welche einen Eingang und einen mit dem Steueranschluss des zweiten Schaltmittels elektrisch leitfähig verbundenen Ausgang aufweist, wobei der Eingang der Regelschaltung elektrisch leitfähig mit der elektrisch leitfähigen Verbindung zwischen dem elektrischen Pfad und dem ersten Anschluss des Spannungsbegrenzungselementes verbunden ist. Ferner bevorzugt ist der Eingang der Regelschaltung direkt mit dem elektrischen Pfad elektrisch leitfähig verbunden. Während durch die Kombination aus Spannungsbegrenzungselement, Referenzspannungsquelle und Kondensator eine sehr schnelle und genaue Spannungsspitzenbegrenzung erreicht wird, ermöglicht eine Regelschaltung eine langsame Anpassung beziehungsweise Begrenzung des Stromes.

In einer bevorzugten Weiterentwicklung dieser Ausführungsform ist der Eingang der Regelschaltung elektrisch leitfähig mit einer aus zwei zueinander in Reihe geschalteten Widerständen gebildeten Spannungsteilerschaltung verbunden. Durch eine derartige Spannungsteilerschaltung lässt sich über die Wahl der Widerstandswerte des ersten und zweiten Widerstandes der Spannungsteilerschaltung eine an der Spannungsteilerschaltung anliegende Gesamtspannung auf eine gewünschte Teilspannung herunterbrechen.

Bevorzugt weist die Regelschaltung einen rückgekoppelten Operationsverstärker auf, dessen Ausgang elektrisch leitfähig mit dem Ausgang der Regelschaltung verbunden ist, dessen nicht-invertierender Eingang elektrisch leitfähig zwischen den Widerständen der Spannungsteilerschaltung mit der Spannungsteilerschaltung verbunden ist und in dessen Rückkopplungszweig ein weiterer Kondensator angeordnet ist. In einem solchen Ausführungsbeispiel ist die Spannung am nicht-invertierenden Eingang des Operationsverstärkers um den Faktor R₂ / (R₁ + R₂) reduziert, wobei R₁ der Widerstandswert des ersten Widerstandes der Spannungsteilerschaltung ist und wobei R₂ der Widerstandswert des zweiten Widerstandes der Spannungsteilerschaltung ist. Mit einem Kondensator im Rückkopplungszweig fungiert die Regelschaltung als Integratorschaltung beziehungsweise als Integrierverstärker.

Vorzugsweise ist der invertierende Eingang des rückgekoppelten Operationsverstärkers elektrisch leitfähig mit einem Pol einer weiteren Spannungsquelle verbunden. Die weitere Spannungsquelle legt den invertierenden Eingang des Operationsverstärkers auf ein vorbestimmtes Potenzial, um die Regelschaltung beziehungsweise den rückgekoppelten Operationsverstärker auf zu brechende Spannungsspitzen einzustellen.

Bevorzugt ist der Ausgang der Regelschaltung über eine Darlington-Schaltung elektrisch leitfähig mit dem Steueranschluss des zweiten Schaltmittels verbunden. Der Vorteil einer solchen Darlington-Schaltung ist, dass mit ihrer Verwendung bei gleichbleibendem Platzbedarf eine erheblich höhere Stromverstärkung erreicht werden kann, beziehungsweise die notwendigen Steuerströme für selbige geringer sind.

Vorzugsweise weist die Reglerspannung U_{regler}, ab deren Anliegen am Eingang der Regelschaltung die Regelschaltung eine Öffnung des zweiten Schaltmittels veranlasst, einen kleineren Betrag auf als die von der Referenzspannungsquelle bereitgestellte Referenzspannung Ur. In einem solchen Ausführungsbeispiel setzt die langsamere Ausregelung von Spannungsspitzen durch die Regelschaltung vor der schnellen, dynamischen Ausregelung durch die Kombination aus Spannungsbegrenzungselement, Referenzspannungsquelle und Kondensator ein. Dadurch erfolgt die Ausregelung von Spannungsspitzen noch sicherer.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 eine Inverterschaltung 80 des Standes der Technik in einem mit einem Energiespeicher 90 und einer Last 100 verbundenen Zustand,
Figur 2 ein erstes Ausführungsbeispiel einer erfindungsgemäßen Inverterschaltung ohne Regelschaltung,
Figur 3 ein zweites Ausführungsbeispiel einer erfindungsgemäßen Inverterschaltung, und
Figur 4 ein drittes Ausführungsbeispiel einer erfindungsgemäßen Inverterschaltung mit erfindungsgemäßer Regelschaltung.

### Ausführungsformen der Erfindung

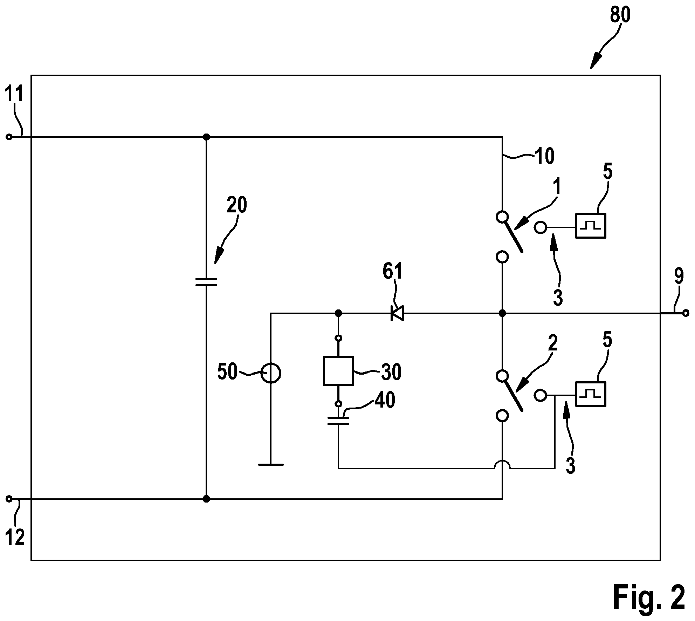

In der Figur 2 ist ein erstes Ausführungsbeispiel einer erfindungsgemäßen Inverterschaltung 80 ohne Regelschaltung 70 dargestellt. Der Aufbau der Inverterschaltung 80 in diesem ersten Ausführungsbeispiel ist in wesentlichen Teilen identisch zu der in Figur 1 dargestellten Inverterschaltung 80 des Standes der Technik, welche in Figur 1 in einem mit einem Energiespeicher 90 und einer Last 100 verbunden Zustand dargestellt ist. Die gleich bezeichneten Komponenten in Figur 2 entsprechen also jenen des in Figur 1 gezeigten Beispiels einer Inverterschaltung 80 des Standes der Technik beziehungsweise den vorhergehend beschriebenen. In diesem ersten Ausführungsbeispiel weist die Inverterschaltung 80 einen Kondensator 40 auf, welcher in der elektrisch leitfähigen Verbindung zwischen dem Spannungsbegrenzungselement 30 und dem Steueranschluss 3 des zweiten Schaltmittels 2 angeordnet ist. Mit anderen Worten ausgedrückt, ist der Kondensator 40 in der elektrisch leitfähigen Verbindung zwischen dem zweiten Anschluss des Spannungsbegrenzungselementes 30 und dem Steueranschluss 3 des zweiten Schaltmittels 2 angeordnet. Ferner umfasst die Inverterschaltung 80 in diesem ersten Ausführungsbeispiel rein beispielhaft eine Referenzspannungsquelle 50, welche elektrisch leitfähig mit dem ersten Anschluss des Spannungsbegrenzungselementes 30 verbunden ist. Der zweite, nicht mit dem ersten Anschluss des Spannungsbegrenzungselementes 30 verbundene Pol der Referenzspannungsquelle 50 ist in diesem ersten Ausführungsbeispiel rein beispielhaft mit dem Massepotenzial verbunden. Er kann aber auch mit einem beliebigen anderen Potenzial verbunden sein. Die mit den Steueranschlüssen 3 des ersten und zweiten Schaltmittels 1, 2 verbundenen Pulsgeber 5 sind jeweils dazu ausgebildet, dass jeweilige Schaltmittel 1, 2, mit welchem sie verbunden sind, entsprechend eines für das jeweilige Schaltmittel 1, 2 vorgegebenen Taktes beziehungsweise Schemas zu öffnen beziehungsweise zu schließen. Der elektrische Pfad 10 verbindet das erste und das zweite Schaltmittel 1, 2 mit den Eingängen 11, 12 der Inverterschaltung 80.

Ferner umfasst das in Figur 2 dargestellte erste Ausführungsbeispiel einer erfindungsgemäßen Inverterschaltung 80 eine optionale erste Diode 61, welche in der elektrisch leitfähigen Verbindung zwischen dem ersten Anschluss des Spannungsbegrenzungselementes 30 und dem elektrischen Pfad 10 angeordnet ist. In diesem ersten Ausführungsbeispiel ist die Anode der ersten Diode 61 elektrisch leitfähig mit dem elektrischen Pfad 10 verbunden, während die Kathode der ersten Diode 61 elektrisch leitfähig mit dem ersten Anschluss des Spannungsbegrenzungselementes 30 verbunden ist. Die erste Diode 61 verhindert, dass eine von der Referenzspannungsquelle 50 erzeugte Referenzspannung an den Ausgang 9 weitergereicht wird. Es können allerdings auch erfindungsgemäße Inverterschaltungen 80 realisiert werden, bei welchen eine Weiterreichung der von der Referenzsspannungsquelle 50 erzeugten Referenzsspannung durch andere Bauelemente beziehungsweise ganz anders verhindert wird.

Das Spannungsbegrenzungselement 30 hat die Eigenschaft, einen sehr hohen Widerstandswert bis zum Überschreiten einer für das Spannungsbegrenzungselement 30 charakteristischen Durchbruchspannung bereitstellen zu können, wobei ab Überschreitung der charakteristischen Durchbruchspannung das Spannungsbegrenzungselement 30 elektrisch leitfähig, also niederohmig wird. In diesem ersten Ausführungsbeispiel gilt für die Referenzspannung Ur, welche von der Referenzspannungsquelle 50 bereitgestellt wird, Ur = Uc + Uspb, wobei Uc der Spannung am Kondensator 40 im vollgeladenen Zustand entspricht und Uspb der Durchbruchspannung des Spannungsbegrenzungselementes 30 entspricht. Mit anderen Worten ausgedrückt, stellt die Referenzspannungsquelle 50 in diesem ersten Ausführungsbeispiel rein beispielhaft eine Referenzspannung Ur bereit, welche über dem Spannungsbegrenzungselement 30 und dem Kondensator 40 abfällt. Ist der Kondensator 40 vollständig geladen, fällt über dem Spannungsbegrenzungselement 30 aufgrund der auf den Kondensator 40 und das Spannungsbegrenzungselement 30 abgestimmten Wahl des Betrages der Referenzspannung Ur genau die Durchbruchspannung Uspb ab. Eine im elektrischen Pfad 10 gegebene Spannungsspitze beziehungsweise Überspannung führt dann unmittelbar zum Durchbruch des Spannungsbegrenzungselementes 30. Dies wiederum führt dazu, dass die Spannung über das Spannungsbegrenzungselement 30 an den Steueranschluss 3 des zweiten Schaltmittels 2 weitergereicht wird, welches daraufhin schließt, sodass sich die Spannungsspitze im elektrischen Pfad 10 abbaut. Das erste und zweite Schaltmittel 1, 2 können beliebig, beispielsweise als IGBTs, als Halbleiterventile, als MOSFETs oder als ganz andere Schaltmittel 1, 2, ausgeführt sein. Ferner können auch erfindungsgemäße Inverterschaltungen 80 ausgeführt werden, bei welchen die von der Referenzspannungsquelle 50 bereitgestellte Referenzspannung Ur anders ausgelegt ist, beispielsweise so, dass nur bestimmte Spannungsspitzen einer vorbestimmten Stärke zu einem Durchbruch des Spannungsbegrenzungselementes 30 führen. Ferner kann das Spannungsbegrenzungselement 30 auch noch zu weiteren Bauelementen in Reihe geschaltet sein, über welchen die von der Referenzspannungsquelle 50 bereitgestellte Referenzspannung Ur abfällt und auf welche die Referenzspannung Ur so abgestimmt ist, dass über dem Spannungsbegrenzungselement 30 genau die Durchbruchspannung Uspb oder eine vorbestimmte andere Spannung abfällt.

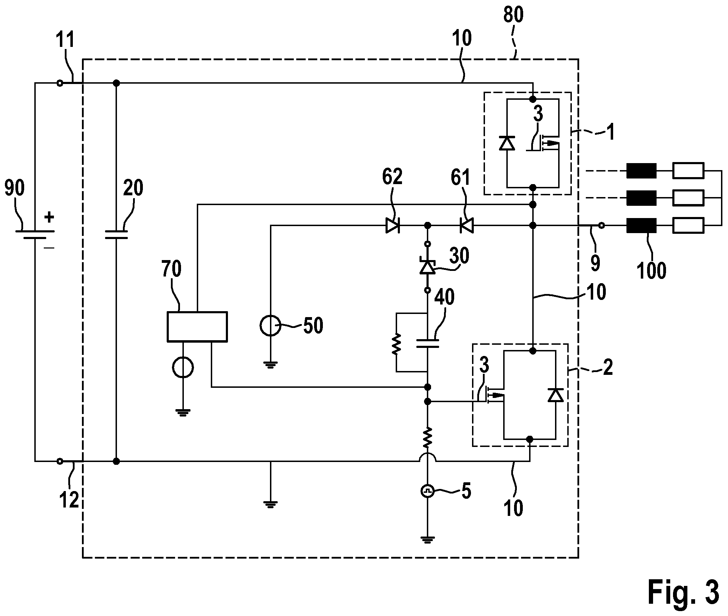

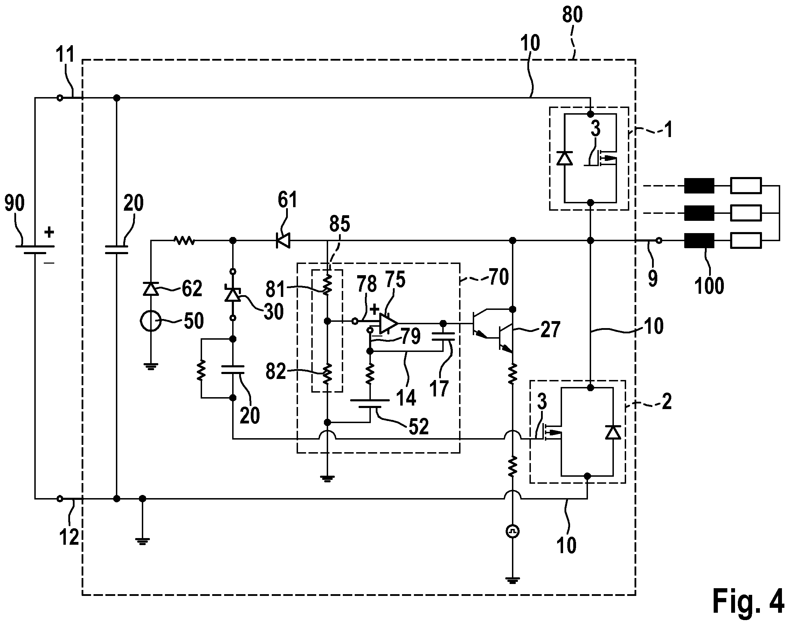

Die Figur 3 zeigt ein zweites Ausführungsbeispiel einer erfindungsgemäßen Inverterschaltung 80 im mit einer Last 100 und einem Energiespeicher 90 elektrisch leitfähig verbundenen Zustand. Das zweite Ausführungsbeispiel ist in wesentlichen Teilen identisch zu dem in Figur 2 gezeigten und zuvor beschriebenen ersten Ausführungsbeispiel, sodass die gleich bezeichneten Komponenten in Figur 3 den in Figur 2 und Figur 1 dargestellten und zuvor beschriebenen Komponenten entsprechen. Im zweiten Ausführungsbeispiel sind das erste und das zweite Schaltmittel 1, 2 rein beispielhaft als Halbleiterventile ausgeführt. In diesem zweiten Ausführungsbeispiel umfasst die Inverterschaltung 80 ferner eine zweite Diode 62, welche in der elektrisch leitfähigen Verbindung zwischen der Referenzspannungsquelle 50 und dem ersten Anschluss des Spannungsbegrenzungselementes 30 angeordnet ist. Mit anderen Worten ausgedrückt, umfasst die Inverterschaltung 80 in diesem zweiten Ausführungsbeispiel rein beispielhaft eine zweite Diode 62, deren Anode elektrisch leitfähig mit einem Pol der Referenzspannungsquelle 50 verbunden ist, während die Kathode der zweiten Diode 62 elektrisch leitfähig mit der Kathode der ersten Diode 61 sowie mit der Kathode des in diesem zweiten Ausführungsbeispiel rein beispielhaft als Zener-Diode 30 ausgeführten Spannungsbegrenzungselementes 30 verbunden ist. In Figur 3 ist das zweite Ausführungsbeispiel einer erfindungsgemäßen Inverterschaltung 80 rein beispielhaft mit einem nicht zu der Inverterschaltung 80 gehörenden Energiespeicher 90 verbunden. Der mit dem negativen Pol des Energiespeichers 90 verbindbare beziehungsweise in diesem zweiten Ausführungsbeispiel verbundene Eingang 12 der Inverterschaltung 80 ist in diesem zweiten Ausführungsbeispiel rein beispielhaft mit dem Massepotenzial verbunden. Ferner ist dem Kondensator 40 in diesem zweiten Ausführungsbeispiel ein Widerstand parallel geschaltet. Des Weiteren weist das zweite Ausführungsbeispiel der Inverterschaltung 80 eine Regelschaltung 70 auf, welche in Figur 4 näher beschrieben wird.

In Figur 4 ist ein drittes Ausführungsbeispiel einer erfindungsgemäßen Inverterschaltung 80 mit einer erfindungsgemäßen Regelschaltung 70 dargestellt. Bei dem in Figur 4 gezeigten dritten Ausführungsbeispiel einer erfindungsgemäßen Inverterschaltung 80 handelt es sich im Wesentlichen um das in Figur 3 dargestellte zweite Ausführungsbeispiel einer Inverterschaltung 80. Die gleich bezeichneten Komponenten des in Figur 4 dargestellten dritten Ausführungsbeispiels entsprechen also jenen des in Figur 3 dargestellten sowie zuvor beschriebenen zweiten Ausführungsbeispiels. In diesem dritten Ausführungsbeispiel umfasst die Inverterschaltung 80 rein beispielhaft eine Regelschaltung 70, welche einen Eingang und einen mit dem Steueranschluss 3 des zweiten Schaltmittels 2 elektrisch leitfähig verbundenen Ausgang aufweist, wobei der Eingang der Regelschaltung 70 elektrisch leitfähig mit der elektrisch leitfähigen Verbindung zwischen dem elektrischen Pfad 10 und dem ersten Anschluss des Spannungsbegrenzungselementes 30, also in diesem dritten Ausführungsbeispiel der Zener-Diode 30, verbunden ist. Es können allerdings auch erfindungsgemäße Inverterschaltungen 80 mit Regelschaltungen 70 ausgeführt werden, deren Eingang direkt mit dem elektrischen Pfad 10 elektrisch leitfähig verbunden ist. Der Eingang der Regelschaltung 70 ist in diesem dritten Ausführungsbeispiel rein beispielhaft elektrisch leitfähig mit einer aus zwei zueinander in Reihe geschalteten Widerständen 81, 82 gebildeten Spannungsteilerschaltung 85 verbunden. Diese über den Eingang der Regelschaltung 70 mit dem elektrischen Pfad 10 verbundene Spannungsteilerschaltung 85 ist ihrerseits mit einem rückgekoppelten Operationsverstärker 75 verbunden, welcher von der Regelschaltung 70 aufgewiesen wird. Der Ausgang des Operationsverstärkers 75 ist elektrisch leitfähig mit dem Ausgang der Regelschaltung 70 verbunden. Die Verbindung zwischen der Spannungsteilerschaltung 85 und dem Operationsverstärker 75 erfolgt über dessen nicht-invertierenden Eingang 78, welcher elektrisch leitfähig zwischen den Widerständen 81, 82 der Spannungsteilerschaltung 85 mit der Spannungsteilerschaltung 85 verbunden ist. Im Rückkopplungszweig 14 des Operationsverstärkers 75 ist in diesem dritten Ausführungsbeispiel ein weiterer Kondensator 17 angeordnet. Mit anderen Worten ausgedrückt, fungiert der über den weiteren Kondensator 17 zurückgekoppelte Operationsverstärker 75 in diesem dritten Ausführungsbeispiel rein beispielhaft als Integrator beziehungsweise als Integrierverstärker.

In diesem dritten Ausführungsbeispiel ist der invertierende Eingang 79 des rückgekoppelten Operationsverstärkers 75 elektrisch leitfähig mit einem Pol einer weiteren Spannungsquelle 52 verbunden, wobei zwischen dem Operationsverstärker 75 und der weiteren Spannungsquelle 52 beziehungsweise in der diese beiden zuletzt genannten Elemente verbindenden elektrischen Verbindung rein beispielhaft ein weiterer Widerstand angeordnet ist. Der nicht mit dem invertierenden Eingang 79 verbundene Pol der weiteren Spannungsquelle 52 ist in diesem dritten Ausführungsbeispiel rein beispielhaft elektrisch leitfähig mit dem Massepotenzial verbunden. Der Ausgang der Regelschaltung 70 ist in diesem dritten Ausführungsbeispiel rein beispielhaft über eine Darlington-Schaltung 27 elektrisch leitfähig mit dem Steueranschluss 3 des zweiten Schalmittels 2 verbunden. Dabei liegt rein beispielhaft ein weiterer Widerstand in der elektrisch leitfähigen Verbindung zwischen der Darlington-Schaltung 27 und dem Steueranschluss 3 des zweiten Schaltmittels 2. In diesem dritten Ausführungsbeispiel weist die Reglerspannung U_{regler}, ab deren Anliegen am Eingang der Regelschaltung 70 die Regelschaltung 70 eine Öffnung des zweiten Schaltmittels 2 veranlasst, einen kleineren Betrag auf, als die von der Referenzspannungsquelle 50 bereitgestellte Referenzspannung Ur.

Bei Vorliegen einer Spannungsspitze beziehungsweise einer Überspannung am Ausgang 9 der Inverterschaltung 80 beziehungsweise zwischen dem ersten und dem zweiten Schaltmittel 1, 2 im elektrischen Pfad 10 liegt diese Spannungsspitze beziehungsweise Überspannung auch am Eingang der Regelschaltung 70 an. Die am nicht-invertierenden Eingang 78 anliegende Spannung ist um einen Faktor reduziert, welcher sich aus dem Verhältnis des Widerstandes 82 zu der Summe aus den Widerständen 81 und 82 ergibt. Die weitere Spannungsquelle 52 stellt am invertierenden Eingang 79 eine Spannung bereit. Übersteigt die am nicht-invertierenden Eingang 78 des Operationsverstärkers 75 anliegende Spannung die von der weiteren Spannungsquelle 52 bereitgestellte Spannung, so wird die Differenz aus diesen Spannungen durch den rückgekoppelten Operationsverstärker 75 aufintegriert und am Ausgang des rückgekoppelten Operationsverstärkers 75 ausgegeben, was zu einer Verstärkung beziehungsweise Öffnung der Darlington-Schaltung 27 am Ausgang der Regelschaltung 70 führt. Dies wiederum bewirkt über den Steueranschluss 3 des zweiten Schaltmittels 2 eine Öffnung des zweiten Schaltmittels 2, was zu einem Abbau der Spannungsspitze beziehungsweise der Überspannung am elektrischen Pfad 10 führt.

## Patentansprüche

1. Inverterschaltung (80), umfassend
- ein erstes und ein zweites Schaltmittel (1, 2), welche in einem elektrischen Pfad (10) zueinander in Reihe und zu einem Zwischenkreiskondensator (20) parallel geschaltet sind und deren Steueranschlüsse (3) jeweils mit einer Pulssteuereinrichtung (5) verbunden sind;
- einen Ausgang (9) und zwei Eingänge (11,12), welche jeweils elektrisch leitfähig mit einem Pol des Zwischenkreiskondensators (20) verbunden und mit jeweils einem Pol eines Energiespeichers verbindbar sind;
- ein Spannungsbegrenzungselement (30), welches mit einem ersten Anschluss zwischen den beiden Schaltmitteln (1, 2) mit dem elektrischen Pfad (10) und mit einem zweiten Anschluss mit dem Steueranschluss (3) des zweiten Schaltmittels (2) elektrisch leitfähig verbunden ist; wobei ein Kondensator (40) in der elektrisch leitfähigen Verbindung zwischen dem Spannungsbegrenzungselement (30) und dem Steueranschluss (3) des zweiten Schaltmittels (2) angeordnet ist,
**dadurch gekennzeichnet, dass** eine Referenzspannungsquelle (50) elektrisch leitfähig mit dem ersten Anschluss des Spannungsbegrenzungselementes (30) verbunden ist,
wobei für die Referenzspannung Ur, welche von der Referenzspannungsquelle (50) bereitgestellt wird, Ur = Uc + Uspb gilt, wobei Uc der Spannung am Kondensator (40) im vollgeladenen Zustand entspricht und Uspb der Durchbruchspannung des Spannungsbegrenzungselementes (30) entspricht.

2. Inverterschaltung (80) nach Anspruch 1, ferner umfassend eine erste Diode (61), welche in der elektrisch leitfähigen Verbindung zwischen dem ersten Anschluss des Spannungsbegrenzungselementes (30) und dem elektrischen Pfad (10) angeordnet ist.

3. Inverterschaltung (80) nach einem der vorhergehenden Ansprüche, ferner umfassend eine zweite Diode (62), welche in der elektrisch leitfähigen Verbindung zwischen der Referenzspannungsquelle (50) und dem ersten Anschluss des Spannungsbegrenzungselementes (30) angeordnet ist.

4. Inverterschaltung (80) nach einem der vorhergehenden Ansprüche, wobei das Spannungsbegrenzungselement (30) als Zener-Diode (30) ausgeführt ist.

5. Inverterschaltung (80) nach einem der vorhergehenden Ansprüche, ferner umfassend eine Regelschaltung (70), welche einen Eingang und einen mit dem Steueranschluss (3) des zweiten Schaltmittels (2) elektrisch leitfähig verbundenen Ausgang aufweist, wobei der Eingang der Regelschaltung (70) elektrisch leitfähig mit der elektrisch leitfähigen Verbindung zwischen dem elektrischen Pfad (10) und dem ersten Anschluss des Spannungsbegrenzungselementes (30) verbunden ist.

6. Inverterschaltung (80) nach Anspruch 5, wobei der Eingang der Regelschaltung (70) elektrisch leitfähig mit einer aus zwei zueinander in Reihe geschalteten Widerständen (81, 82) gebildeten Spannungsteilerschaltung (85) verbunden ist.

7. Inverterschaltung (80) nach Anspruch 6, wobei die Regelschaltung (70) einen rückgekoppelten Operationsverstärker (75) aufweist, dessen Ausgang elektrisch leitfähig mit dem Ausgang der Regelschaltung (70) verbunden ist, dessen nicht-invertierender Eingang (78) elektrisch leitfähig zwischen den Widerständen (81, 82) der Spannungsteilerschaltung (85) mit der Spannungsteilerschaltung (85) verbunden ist und in dessen Rückkopplungszweig (14) ein weiterer Kondensator (17) angeordnet ist.

8. Inverterschaltung (80) nach Anspruch 7, wobei der invertierende Eingang (79) des rückgekoppelten Operationsverstärkers (75) elektrisch leitfähig mit einem Pol einer weiteren Spannungsquelle (52) verbunden ist.

9. Inverterschaltung (80) nach einem der Ansprüche 5 bis 8, wobei der Ausgang der Regelschaltung (70) über eine Darlington-Schaltung (27) elektrisch leitfähig mit dem Steueranschluss (3) des zweiten Schaltmittels (2) verbunden ist.

10. Inverterschaltung (80) nach einem der Ansprüche 5 bis 9, wobei die Reglerspannung U_{regler}, ab deren Anliegen am Eingang der Regelschaltung (70) die Regelschaltung (70) eine Öffnung des zweiten Schaltmittels (2) veranlasst, einen kleineren Betrag aufweist als die von der Referenzspannungsquelle (50) bereitgestellte Referenzspannung Ur.

## Claims

1. Inverter circuit (80), comprising
- a first and a second switching means (1, 2), which, in an electrical path (10), are connected in series with one another and in parallel with a link circuit capacitor (20) and the control terminals (3) of which are in each case connected to a pulse control device (5);
- an output (9) and two inputs (11, 12), which are in each case electrically conductively connected to a pole of the link circuit capacitor (20) and are connectable respectively to a pole of an energy store;
- a voltage limiting element (30), which is electrically conductively connected to the electrical path (10) by a first terminal between the two switching means (1, 2) and to the control terminal (3) of the second switching means (2) by a second terminal; wherein
a capacitor (40) is arranged in the electrically conductive connection between the voltage limiting element (30) and the control terminal (3) of the second switching means (2),
**characterized in that** a reference voltage source (50) is electrically conductively connected to the first terminal of the voltage limiting element (30), wherein for the reference voltage Ur provided by the reference voltage source (50), Ur = Uc + Uspb holds true, wherein Uc corresponds to the voltage at the capacitor (40) in the fully charged state and Uspb, corresponds to the breakdown voltage of the voltage limiting element (30).

2. Inverter circuit (80) according to Claim 1, furthermore comprising a first diode (61), which is arranged in the electrically conductive connection between the first terminal of the voltage limiting element (30) and the electrical path (10).

3. Inverter circuit (80) according to either of the preceding claims, furthermore comprising a second diode (62), which is arranged in the electrically conductive connection between the reference voltage source (50) and the first terminal of the voltage limiting element (30).

4. Inverter circuit (80) according to any of the preceding claims, wherein the voltage limiting element (30) is embodied as a Zener diode (30).

5. Inverter circuit (80) according to any of the preceding claims, furthermore comprising a regulating circuit (70) having an input and an output, which is electrically conductively connected to the control terminal (3) of the second switching means (2), wherein the input of the regulating circuit (70) is electrically conductively connected to the electrically conductive connection between the electrical path (10) and the first terminal of the voltage limiting element (30).

6. Inverter circuit (80) according to Claim 5, wherein the input of the regulating circuit (70) is electrically conductively connected to a voltage divider circuit (85) formed from two resistors (81, 82) connected in series with one another.

7. Inverter circuit (80) according to Claim 6, wherein the regulating circuit (70) has a feedback operational amplifier (75), the output of which is electrically conductively connected to the output of the regulating circuit (70) and the non-inverting input (78) of which is electrically conductively connected to the voltage divider circuit (85) between the resistors (81, 82) of the voltage divider circuit (85) and in the feedback branch (14) of which a further capacitor (17) is arranged.

8. Inverter circuit (80) according to Claim 7, wherein the inverting input (79) of the feedback operational amplifier (75) is electrically conductively connected to a pole of a further voltage source (52) .

9. Inverter circuit (80) according to any of Claims 5 to 8, wherein the output of the regulating circuit (70) is electrically conductively connected to the control terminal (3) of the second switching means (2) via a Darlington circuit (27).

10. Inverter circuit (80) according to any of Claims 5 to 9, wherein the regulator voltage U_{regulator}, the regulating circuit (70) causing the second switching means (2) to open upon said regulator voltage being present at the input of the regulating circuit (70), has a smaller magnitude than the reference voltage Ur provided by the reference voltage source (50).

## Revendications

1. Circuit onduleur (80), comprenant
- un premier et un deuxième moyen de commutation (1, 2), lesquels sont branchés en série l'un avec l'autre dans un trajet électrique (10) et en parallèle avec un condensateur de circuit intermédiaire (20) et dont les bornes de commande (3) sont respectivement reliées à un dispositif de commande par impulsions (5) ;
- une sortie (9) et deux entrées (11, 12), lesquelles sont respectivement reliées de manière électriquement conductrice à un pôle du condensateur de circuit intermédiaire (20) et peuvent respectivement être reliées à un pôle d'un accumulateur d'énergie ;
- un élément de limitation de tension (30), lequel est relié de manière électriquement conductrice par une première borne au trajet électrique (10) entre les deux moyens de commutation (1, 2) et par une deuxième borne à la borne de commande (3) du deuxième moyen de commutation (2) ;
un condensateur (40) étant disposé dans la liaison électriquement conductrice entre l'élément de limitation de tension (30) et la borne de commande (3) du deuxième moyen de commutation (2),
**caractérisé en ce qu'**une source de tension de référence (50) est reliée de manière électriquement conductrice à la première borne de l'élément de limitation de tension (30),
la tension de référence Ur qui est délivrée par la source de tension de référence (50) vérifiant la relation Ur = Uc + Uspb, Uc désignant la tension aux bornes du condensateur (40) à l'état entièrement chargé et Uspb la tension de claquage de l'élément de limitation de tension (30).

2. Circuit onduleur (80) selon la revendication 1, comprenant en outre une première diode (61) qui est disposée dans la liaison électriquement conductrice entre la première borne de l'élément de limitation de tension (30) et le trajet électrique (10).

3. Circuit onduleur (80) selon l'une des revendications précédentes, comprenant en outre une deuxième diode (62) qui est disposée dans la liaison électriquement conductrice entre la source de tension de référence (50) et la première borne de l'élément de limitation de tension (30).

4. Circuit onduleur (80) selon l'une des revendications précédentes, l'élément de limitation de tension (30) étant réalisé sous la forme d'une diode Zener (30).

5. Circuit onduleur (80) selon l'une des revendications précédentes, comprenant en outre un circuit de régulation (70), lequel possède une entrée et une sortie reliée de manière électriquement conductrice à la borne de commande (3) du deuxième moyen de commutation (2), l'entrée du circuit de régulation (70) étant reliée de manière électriquement conductrice à la liaison électriquement conductrice entre le trajet électrique (10) et la première borne de l'élément de limitation de tension (30).

6. Circuit onduleur (80) selon la revendication 5, l'entrée du circuit de régulation (70) étant reliée de manière électriquement conductrice à un circuit diviseur de tension (85) formé par deux résistances (81, 82) branchées en série l'une avec l'autre.

7. Circuit onduleur (80) selon la revendication 6, le circuit de régulation (70) possédant un amplificateur opérationnel (75) à contre-réaction dont la sortie est reliée de manière électriquement conductrice à la sortie du circuit de régulation (70), dont l'entrée non inverseuse (78) est reliée de manière électriquement conductrice entre les résistances (81, 82) du circuit diviseur de tension (85) au circuit diviseur de tension (85) et dans la branche de contre-réaction (14) duquel est disposé un condensateur supplémentaire (17).

8. Circuit onduleur (80) selon la revendication 7, l'entrée inverseuse (79) de l'amplificateur opérationnel (75) à contre-réaction étant reliée de manière électriquement conductrice à un pôle d'une source de tension supplémentaire (52).

9. Circuit onduleur (80) selon l'une des revendications 5 à 8, la sortie du circuit de régulation (70) étant reliée de manière électriquement conductrice par le biais d'un circuit en Darlington (27) à la borne de commande (3) du deuxième moyen de commutation (2).

10. Circuit onduleur (80) selon l'une des revendications 5 à 9, la tension de régulateur U_{regler}, à partir de l'application de laquelle à l'entrée du circuit de régulation (70), le circuit de régulation (70) provoque une ouverture du deuxième moyen de commutation (2), possédant une valeur inférieure à la tension de référence Ur délivrée par la source de tension de référence (50).
